# FASCICULE DE BREVET EUROPEEN

(11) **EP 3 242 335 B1**
(45) Date de publication et mention de la délivrance du brevet: **13.11.2019**
(21) Numéro de dépôt: 17169271.8
(22) Date de dépôt: 03.05.2017
(51) Int. Cl.: H01L 31/0747, H01L 31/18

(54) **PROCÉDÉ DE FABRICATION D'UNE CELLULE PHOTOVOLTAÏQUE À HÉTÉROJONCTION**
VERFAHREN ZUR HERSTELLUNG EINER FOTOVOLTAISCHEN ZELLE MIT EINEM HETEROÜBERGANG
PROCESS FOR MANUFACTURING A HETEROJUNCTION PHOTOVOLTAIC CELL

(30) Priorité: 03.05.2016 FR 1654011
(43) Date de publication de la demande: 08.11.2017
(73) Titulaire: Commissariat à l'Energie Atomique et aux Energies Alternatives, 75015 Paris (FR)
(72) Inventeur: CARRERE, Tristan, 09300 LAVELANET (FR); HARRISON, Samuel, 38530 PONTCHARRA (FR)
(74) Mandataire: Cabinet Camus Lebkiri

(56) Documents cités:
- EP-A2- 2 051 307
- WO-A1-2014/206504
- WO-A1-2015/044070
- US-A1- 2008 075 840

## Description

### DOMAINE TECHNIQUE DE L'INVENTION

Le domaine technique de l'invention est celui des cellules photovoltaïques à hétérojonction, et plus particulièrement celui de la guérison de défauts à l'interface entre un substrat en silicium cristallin et une couche de passivation.

### ARRIÈRE-PLAN TECHNOLOGIQUE DE L'INVENTION

Par définition, dans une cellule photovoltaïque à hétérojonction, les couches semi-conductrices dopées de type p et n formant la jonction p-n sont composées de matériaux semi-conducteurs ayant des bandes d'énergie interdites différentes. Pour ce faire, les deux couches semi-conductrices peuvent être composées de matériaux semi-conducteurs de natures physiques différentes, ou d'un même matériau semiconducteur ayant des structures cristallographiques différentes. De manière classique, les cellules photovoltaïques à hétérojonction sont fabriquées par dépôt de couches de silicium amorphe sur un substrat en silicium cristallin. Les cellules photovoltaïques à hétérojonction sont dès lors sensibles aux défauts situés à l'interface entre le substrat et le silicium amorphe.

Ces défauts, qui introduisent des niveaux d'énergie dans la bande interdite, peuvent être des liaisons pendantes, également appelées « dangling bonds » en anglais, ou des impuretés telles que des ions métalliques. Les défauts augmentent le nombre de recombinaisons électron-trou à l'interface, ce qui détériore les paramètres de sortie de la cellule photovoltaïque, tels que la tension en circuit ouvert V_{OC}, pour « open circuit voltage » en anglais.

Pour obtenir une cellule photovoltaïque performante, il est donc nécessaire de minimiser le nombre de recombinaisons sur les faces du substrat, ce qui peut être accompli en déposant une couche de silicium amorphe hydrogéné intrinsèque sur chaque face du substrat. En effet, cette couche permet une excellente passivation de surface par l'action des atomes d'hydrogène qui viennent neutraliser les défauts.

A ce stade de fabrication de la cellule photovoltaïque, c'est-à-dire tout de suite après le dépôt du silicium amorphe hydrogéné intrinsèque, il est aisé d'obtenir une bonne passivation de surface, avec une tension en circuit ouvert maximale théorique i-V_{OC}, pour « implied open circuit voltage » en anglais, supérieure à 700 mV. Cependant, la qualité de l'interface peut être grandement diminuée lors d'étapes de fabrication ultérieures. En effet le silicium amorphe est sensible à tout budget thermique, c'est-à-dire aux étapes de fabrication impliquant des températures élevées. Le silicium amorphe est également sensible au bombardement excessif. C'est le cas par exemple des procédés utilisant des plasmas dont les ions traversent le silicium amorphe et viennent modifier les liaisons à l'interface avec le substrat.

Les procédés susceptibles d'endommager l'interface entre le substrat et le silicium amorphe sont par exemple des procédés de dépôt physique en phase vapeur, également appelés PVD pour « Physical Vapour Déposition » en anglais, utilisés pour déposer du métal ou un oxyde transparent conducteur. C'est le cas également des procédés utilisés pour former des motifs dans le silicium amorphe ou l'oxyde transparent conducteur, tels que la gravure par laser ou la gravure ionique réactive. Ces procédés de gravures sont notamment utilisés pour former les cellules photovoltaïques à contacts en face arrière. L'interface peut aussi être endommagée par des procédés d'implantation ionique utilisés pour réaliser le dopage des couches de silicium amorphe ou des sur-dopages.

Afin de conserver une bonne qualité de l'interface entre le silicium cristallin et le silicium amorphe, la stratégie actuellement employée consiste à limiter les dégâts au niveau de cette interface. Pour cela, il est nécessaire de faire des compromis concernant les procédés utilisés au cours de la fabrication tout en obtenant une cellule photovoltaïque ayant les propriétés finales désirées. De manière générale, ces contraintes liées à la fragilité de l'interface limitent le nombre de procédés compatibles avec les spécificités de la couche de silicium amorphe pour la fabrication de cellules photovoltaïques à hétérojonction.

Le document Wang et al., « Improved amorphous/crystalline silicon interface passivation for heterojunction solar cells by low-temperature chemical vapor deposition and post-annealing treatment », Physical Chemistry Chemical Physics, 2014, 16, 20202-20208, décrit l'utilisation d'un recuit permettant à l'hydrogène contenu dans la couche de silicium amorphe de diffuser et de guérir les défauts à l'interface avec le substrat.

Cependant, cette technique présente des résultats limités. En effet, la couche de silicium amorphe n'est pas encapsulée donc une partie de l'hydrogène diffuse hors de la zone cible, c'est-à-dire l'interface. De plus, tout l'hydrogène présent dans la couche de silicium amorphe n'est pas disponible pour la diffusion, une partie des atomes d'hydrogène étant liée à des atomes de silicium. En outre, si le nombre de défauts est trop important, la quantité d'hydrogène présent dans la couche de silicium amorphe n'est pas suffisante pour les guérir. Par exemple, après une étape d'implantation effectuée à haute énergie ou une étape de gravure laser, de nombreux défauts ne sont pas guéris et la qualité de passivation finale n'est pas satisfaisante.

Le document US 2008/075840 A1 décrit un procédé de fabrication d'une cellule photovoltaïque à homojonction, procédé dans lequel l'utilisation d'un recuit à une température située entre 700°C et 900°C permet à l'hydrogène contenu dans une couche anti-réflective de diffuser dans le substrat. Un second recuit à une température située entre 200°C et 500°C est ensuite réalisé pour promouvoir la guérison des défauts du substrat, sous l'action de l'hydrogène introduit dans le substrat. Le document indique également que l'introduction de l'hydrogène dans le substrat peut être obtenue par une étape d'hydrogénation du substrat, par exemple par plasma.

Le document WO 2015/044070 A1 décrit un procédé de fabrication d'une cellule photovoltaïque à hétérojonction, procédé dans lequel de l'hydrogène est diffusé à l'interface entre une couche tunnel de passivation et le substrat, et ce en utilisant une technique d'hydrogénation du substrat sous atmosphère d'hydrogène ionisé via MW-plasma.

Le document EP 2 051 307 A2 décrit un procédé de fabrication d'une cellule photovoltaïque à homojonction, procédé dans lequel une passivation par hydrogène des défauts contenus dans le substrat de silicium est réalisée par implantation d'ions hydrogène (issus d'une source plasma) dans ce substrat.

### RÉSUMÉ DE L'INVENTION

La présente invention vise à améliorer la qualité d'une interface entre un substrat en silicium cristallin et une couche de passivation d'une cellule photovoltaïque à hétérojonction en guérissant des défauts présents à cette interface de manière efficace.

Selon l'invention, ce but est atteint en prévoyant un procédé de fabrication d'une cellule photovoltaïque à hétérojonction comportant les étapes suivantes :
- fournir un substrat en silicium cristallin ;
- implanter des ions d'hydrogène en surface du substrat, à travers une première face du substrat ;
- déposer une couche de passivation sur la première face du substrat ;
- effectuer un traitement thermique à une température inférieure à 250°C de sorte que les ions d'hydrogène implantés dans le substrat diffusent vers l'interface entre le substrat et la couche de passivation.

On entend par traitement thermique toute opération consistant à soumettre le substrat à une élévation de température afin d'en modifier les propriétés, par exemple physiques, électriques ou mécaniques. Un recuit est un exemple de traitement thermique.

Ainsi, grâce à l'invention, les défauts d'interface sont neutralisés par l'hydrogène implanté dans le substrat, ce qui améliore la qualité de la passivation. Le procédé selon l'invention fait donc intervenir une source d'hydrogène indépendante de la couche de passivation pour ne pas en modifier les propriétés. De plus, la guérison étant activée par le traitement thermique, il est possible de choisir quand la déclencher. Le processus de guérison peut donc intervenir à tout moment au cours de la fabrication de la cellule photovoltaïque. Enfin, comme le traitement thermique de diffusion succède à l'implantation des ions d'hydrogène, les éventuels défauts générés par l'implantation ionique sont également guéris.

Le procédé de fabrication selon l'invention peut également comporter une ou plusieurs caractéristiques parmi les suivantes, considérées individuellement ou selon les combinaisons techniquement possibles :
- le procédé comporte en outre des étapes de fabrication susceptibles de provoquer une dégradation de l'interface entre le substrat et la couche de passivation, le traitement thermique étant effectué postérieurement à ces étapes ;
- le traitement thermique est effectué à une température comprise entre 100°C et 220°C ;
- le traitement thermique est effectué pendant une durée comprise entre 1 minute et 30 minutes ;
- l'implantation ionique d'hydrogène est réalisée par immersion dans un plasma ;
- l'implantation ionique d'hydrogène est effectuée à une énergie inférieure à 1 keV ;
- l'implantation ionique d'hydrogène est réalisée à une dose comprise entre 10¹³ atomes/cm³ et 10¹⁷ atomes/cm³ ;
- le traitement thermique est un recuit de sérigraphie, un recuit d'activation de dopants, ou toute étape de dépôt spécifique effectuée à une température comprise entre 100°C et 220°C ;
- la couche de passivation comprend du silicium amorphe, éventuellement hydrogéné, de l'alumine, un oxyde thermique et/ou un nitrure de silicium de type SiNₓH ;
- l'étape d'implantation ionique d'hydrogène et l'étape de dépôt d'une couche de passivation sont en outre mises en œuvre sur une deuxième face du substrat opposée à la première face.

### BRÈVE DESCRIPTION DES FIGURES

L'invention et ses différentes applications seront mieux comprises à la lecture de la description qui suit et à l'examen des figures qui l'accompagnent, parmi lesquelles :
- les figures 1A à 1D représentent schématiquement des étapes d'un procédé de fabrication d'une cellule photovoltaïque à hétérojonction, selon un mode de mise en œuvre préférentiel de l'invention ;
- les figures 2A à 2E représentent schématiquement un premier exemple de mise en œuvre du procédé selon l'invention pour la fabrication d'une première cellule photovoltaïque à hétérojonction et à contacts en face arrière ;
- la figure 3 représente schématiquement un deuxième exemple de mise en œuvre du procédé selon l'invention pour la fabrication d'une deuxième cellule photovoltaïque à hétérojonction.

Les figures ne sont présentées qu'à titre indicatif et nullement limitatif de l'invention.

Pour plus de clarté, les éléments identiques ou similaires sont repérés par des signes de référence identiques sur toutes les figures.

### DESCRIPTION DÉTAILLÉE DE MODES DE MISE EN ŒUVRE DE L'INVENTION

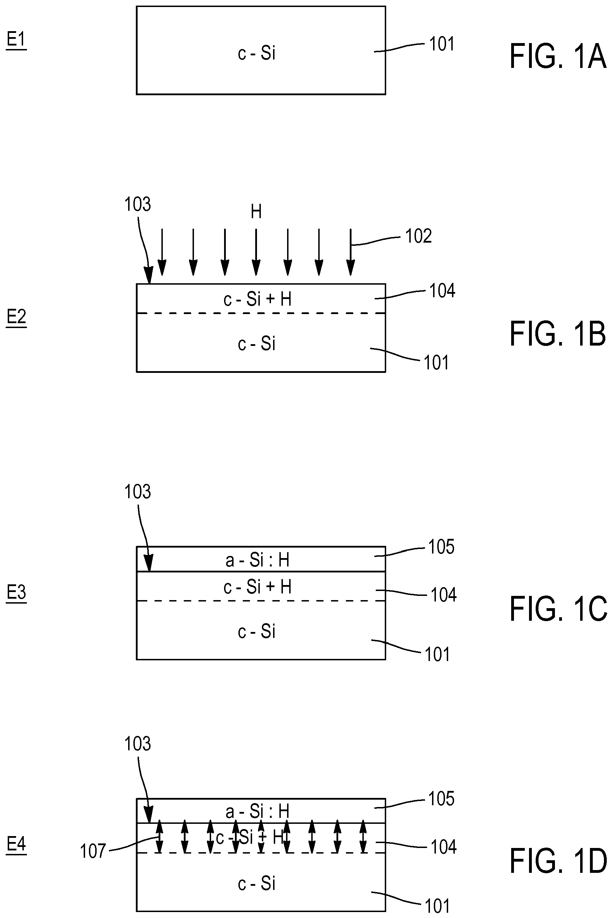

Un mode de mise en œuvre préférentiel du procédé de fabrication d'une cellule photovoltaïque à hétérojonction selon l'invention va maintenant être décrit, en référence aux figures 1A à 1D. Les figures 1A à 1D représentent en vue en coupe transversale la cellule photovoltaïque à différentes étapes du procédé de fabrication.

Un substrat 101 en silicium cristallin c-Si est fourni au cours d'une étape E1. Le substrat 101 présente deux faces opposées.

Au cours d'une étape E2, une implantation ionique d'hydrogène H, représentée par des flèches 102 sur la figure 1B, est réalisée à travers une première face 103 du substrat 101, de sorte à constituer un réservoir d'hydrogène 104 en surface 103 du substrat 101.

De préférence, l'implantation ionique est réalisée de sorte qu'une concentration maximale en hydrogène dans le substrat 101 soit obtenue à une profondeur inférieure à 20 nm. On considère la profondeur par rapport à la première face 103 du substrat 101.

Pour ce faire, l'implantation ionique est par exemple réalisée par immersion dans un plasma. Cette technique, communément appelée PIII pour « Plasma Immersion Ion Implantation » en anglais, permet d'effectuer l'implantation ionique à une énergie faible. Il est ainsi possible de concentrer les atomes d'hydrogène près de la surface 103 du substrat 101. De préférence, l'énergie d'implantation est inférieure à 1000 eV, et plus préférentiellement encore, l'énergie d'implantation est comprise entre 500 et 1000 eV.

De préférence, l'implantation ionique est réalisée à une dose comprise entre 10¹³ atomes/cm³ et 10¹⁷ atomes/cm³, et plus préférentiellement encore, comprise entre 10¹⁵ atomes/cm³ et 10¹⁶ atomes/cm³. Une forte concentration en atomes d'hydrogène, de préférence supérieure à 10²⁰ atomes/cm³, est ainsi obtenue à la surface 103 du substrat 101.

Une telle concentration d'hydrogène permet de guérir la quasi-totalité des défauts situés à la surface 103 du substrat, qui peuvent être dus à la préparation du substrat 101 et aux étapes ultérieures de fabrication de la cellule photovoltaïque à hétérojonction.

Après l'étape d'implantation ionique, une couche de passivation 105 est déposée, au cours d'une étape E3, sur la première face 103 du substrat 101, comme illustré sur la figure 1C. La couche de passivation comprend un matériau permettant de neutraliser les liaisons pendantes ou les défauts existant à la surface du substrat. La neutralisation est effectuée par la création d'une liaison entre la liaison pendante d'un atome de silicium et un atome d'un autre élément chimique, tel que l'hydrogène ou le fluor. La qualité d'une passivation est évaluée par une mesure de durée de vie des porteurs en excès dans le substrat. Les porteurs en excès sont par exemple générés par illumination, injection de courant, ou par une augmentation de température.

La couche de passivation 105 est de préférence en silicium amorphe hydrogéné a-Si:H intrinsèque. Alternativement, la couche de passivation 105 en silicium amorphe hydrogéné peut être dopée, par exemple d'un type de conductivité opposé à celui du substrat 101 pour former aussi un émetteur, ou du même type de conductivité que celui du substrat 101 pour former aussi une couche de champ répulsif pour les porteurs de charge minoritaires. Le dépôt de la couche de silicium amorphe hydrogéné 105 est par exemple réalisé par dépôt chimique en phase vapeur assisté par plasma, également appelé PECVD pour « Plasma-Enhanced Chemical Vapor Déposition » en anglais.

Comme illustré sur la figure 1D, le substrat 101 est ensuite soumis à une étape E4 de traitement thermique de manière à permettre la diffusion, symbolisée par des flèches 107, de l'hydrogène présent dans le réservoir 104 vers l'interface 103 entre le substrat 101 et la couche de passivation 105. L'hydrogène, présent en grande quantité à proximité immédiate de l'interface 103, vient alors passiver la quasi-totalité des défauts de l'interface 103. La qualité de l'interface 103 est ainsi grandement améliorée, ce qui aboutit à de meilleures performances photovoltaïques, en termes de rendement notamment.

De plus, grâce au réservoir d'hydrogène 104, il n'est pas nécessaire que la couche de passivation 105 contienne de l'hydrogène. Il peut alors être envisagé d'utiliser d'autres couches de passivation, contenant par exemple de l'alumine Al₂O₃, un oxyde thermique comme de l'oxyde de silicium SiO₂ obtenu par oxydation thermique, ou un nitrure de silicium de type SiNₓH déposé à basse température. Il est cependant nécessaire que la température de dépôt de la couche de passivation reste dans la gamme de températures spécifique aux cellules photovoltaïques à hétérojonction. Une fois la couche de passivation 105 déposée, l'étape de traitement thermique E4 peut être effectuée à tout moment au cours du procédé de fabrication.

Pour guérir les défauts d'interface dans le procédé de l'art antérieur, un recuit est utilisé pour permettre à l'hydrogène contenu dans une couche de passivation en silicium amorphe de diffuser. Dans le but d'obtenir une meilleure passivation, la quantité initiale d'hydrogène contenu dans la couche de passivation serait augmentée en modifiant les conditions de dépôt. Cependant, l'augmentation de la quantité initiale d'hydrogène a pour conséquence de modifier les propriétés, notamment optiques et électriques, de la couche de passivation. Par exemple, l'augmentation de la quantité d'hydrogène s'accompagne d'une augmentation de la transparence de la couche de passivation. Par ailleurs, lorsque la quantité d'hydrogène devient trop importante, le silicium amorphe commence à cristalliser, ce qui perturbe le fonctionnement de la cellule photovoltaïque. Dans le procédé selon l'invention, l'hydrogène nécessaire à la guérison des défauts provient du réservoir 104. Il n'est donc pas nécessaire d'augmenter la quantité initiale d'hydrogène contenu dans la couche de passivation et celle-ci conserve ses propriétés.

Le procédé de fabrication de la cellule photovoltaïque comporte d'autres étapes dont certaines peuvent endommager l'interface 103 entre le substrat 101 et la couche de passivation 105. C'est le cas notamment des procédés de dépôt physique en phase vapeur utilisés pour déposer du métal ou un oxyde transparent conducteur, des procédés utilisés pour former des motifs dans le silicium amorphe ou l'oxyde transparent conducteur, tels que la gravure par laser ou la gravure ionique réactive, ou encore des procédés d'implantation ionique utilisés pour réaliser le dopage de couches semi-conductrices ou des sur-dopages.

De préférence, l'étape de traitement thermique E4 est effectuée après toutes les étapes du procédé de fabrication susceptibles d'endommager l'interface 103. Cela garantit une efficacité maximale du processus de guérison car, dans ce cas, tous les défauts susceptibles de survenir sont apparus à l'interface 103 entre le substrat 101 et la couche de passivation 105 avant d'effectuer le traitement thermique. Il n'est pas nécessaire d'effectuer le traitement thermique juste après le dépôt de la couche de passivation 105, celle-ci pouvant être recouverte par d'autres couches.

Le procédé selon l'invention est désormais ouvert à plus large choix de procédés pour fabriquer la cellule photovoltaïque, car même si ces procédés génèrent des défauts, ces derniers peuvent être passivés grâce à la diffusion de l'hydrogène du réservoir vers l'interface.

Le traitement thermique est effectué à une température inférieure à 250°C, de préférence comprise entre 100 °C et 220 °C, et plus préférentiellement encore comprise entre 150 °C et 200 °C. Ces températures sont compatibles avec les technologies de fabrication des cellules photovoltaïques à hétérojonction. En effet, la couche de passivation 105 supporte difficilement des températures plus élevées, tout particulièrement lorsqu'elle comprend ou est constituée de silicium amorphe. De plus, lorsqu'une couche de passivation 105 contenant de l'hydrogène est utilisée, cette gamme de température n'implique que des modifications mineures de la concentration en hydrogène de la couche de passivation 105, qui conserve ainsi ses propriétés.

De préférence, le traitement thermique est effectué pendant une durée comprise entre 1 minute et 30 minutes, et plus préférentiellement encore, pendant une durée comprise entre 5 minutes et 15 minutes. Ces conditions de températures et de durée de traitement thermique permettent de limiter la diffusion de l'hydrogène plus en profondeur dans le substrat 101. Ainsi, les ions d'hydrogène restent concentrés en surface et participent en plus grand nombre au processus de guérison.

Avantageusement, l'étape de traitement thermique E4 s'effectue naturellement au cours d'une autre étape du procédé de fabrication impliquant une température comprise entre 100°C et 250°C. Il peut notamment s'agir d'un recuit final de sérigraphie (pour l'activation électrique des contacts), d'un recuit d'activation de dopants, de la création d'une couche d'oxyde transparent conducteur, effectuée par exemple par dépôt physique en phase vapeur (PVD) à 200°C, ou d'une oxydation thermique. Ainsi, il n'est pas nécessaire d'ajouter une étape de traitement thermique supplémentaire, ce qui permet de ne pas augmenter les coûts de production.

Le traitement thermique n'est pas associé à une étape de génération de porteurs de charge minoritaire. Notamment, le traitement thermique est effectué sans illumination.

Alternativement, l'étape de traitement thermique E4 peut être spécifique, c'est-à-dire définie spécialement pour favoriser la diffusion de l'hydrogène vers l'interface. Ainsi, il est possible d'optimiser les paramètres opérationnels, notamment la température et la durée du traitement thermique, afin de maximiser l'efficacité de la guérison des défauts.

L'étape de traitement thermique peut également être une combinaison d'un traitement thermique spécifique et d'un traitement thermique effectué au cours d'une autre étape du procédé de fabrication impliquant une température comprise entre 100°C et 250°C.

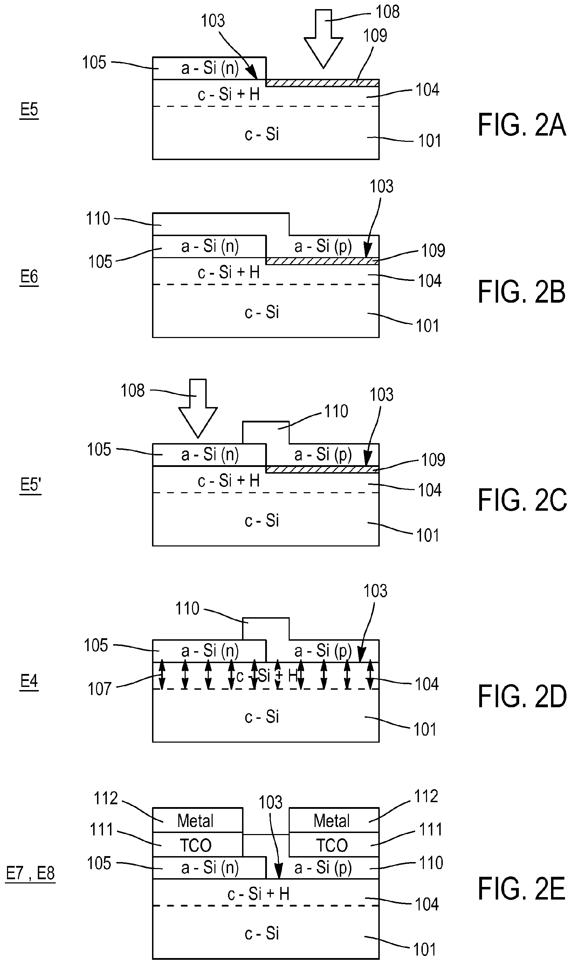

Un premier exemple de mise en œuvre du procédé de fabrication d'une cellule photovoltaïque à hétérojonction selon l'invention va maintenant être décrit, en référence aux figures 2A à 2E. Ces figures représentent certaines étapes de fabrication de la cellule photovoltaïque à contacts en face arrière.

La cellule photovoltaïque à hétérojonction et à contacts en face arrière, communément appelée RCC pour « Rear Contact Cell » en anglais, ou IBC pour « Interdigitated Back Contact » en anglais, comporte une jonction p-n et un ensemble de contacts disposés sur la face arrière de la cellule photovoltaïque, opposée à la face avant de la cellule photovoltaïque, c'est-à-dire la face destinée à recevoir un rayonnement lumineux. Ce type de structure permet d'atteindre des hautes densités de courants grâce à l'absence de contacts sur la face avant.

Tout d'abord, comme décrit précédemment, on réalise l'étape E2 (Fig.1B) consistant à implanter des ions d'hydrogène à travers la première surface 103 du substrat 101 en silicium cristallin, formant ainsi un réservoir d'hydrogène 104, et l'étape E3 (Fig.1C) de dépôt de la couche de passivation 105 sur la première surface 103 du substrat 101. La première surface 103 du substrat 101 correspond ici à la face arrière du substrat. Dans cet exemple de mise en œuvre, la couche de passivation 105 est en silicium amorphe hydrogéné a-Si:H dopée selon un premier type de conductivité, ici dopée n.

La figure 2A illustre une étape E5 d'ablation, encore appelée ouverture ou gravure, de la couche de silicium amorphe 105, au cours de laquelle une partie de la couche de silicium amorphe 105 est éliminée. Cette étape E5 d'ablation, symbolisée par une flèche 108, est par exemple réalisée au moyen d'un laser. L'ablation laser est un procédé agressif produisant une forte chauffe localisée et un bombardement qui causent des dégâts 109 sur la surface 103 du substrat 101, au niveau de la partie de la couche de silicium amorphe 105 supprimée. Une quantité importante d'hydrogène est nécessaire pour réparer les défauts générés au cours de cette étape E5 d'ablation. L'invention est donc particulièrement adaptée à la fabrication de cellules photovoltaïques présentant ce type d'architecture.

Après l'ouverture de la couche de silicium amorphe 105 dopée n, une couche de silicium amorphe 110 dopée selon un deuxième type de conductivité opposé au premier type de conductivité, dans ce cas dopée p, est déposée, au cours d'une étape E6, sur le substrat 101 et sur la partie de la couche de silicium amorphe 105 restante, tel qu'illustré sur la figure 2B. La couche de silicium amorphe dopée p 110 est également soumise à une étape E5' de gravure, comme illustré sur la figure 2C.

L'étape de traitement thermique E4 est ensuite réalisée, comme illustré sur la figure 2D, de manière à faire diffuser les ions hydrogène du réservoir 104 vers l'interface 103 (flèches 107), et ainsi passiver les défauts 109 de l'interface 103.

Le procédé de fabrication de la cellule photovoltaïque à hétérojonction et à contact en face arrière peut également comporter des étapes E7, E8 de dépôt, sur la face arrière, d'un oxyde transparent conducteur 111 (TCO pour « Transparent Conductive Oxide » en anglais) et de contacts métalliques 112, comme illustré sur la figure 2E. Ces étapes sont classiques et ne font pas en propre l'objet de la présente invention. Elles ne seront donc pas ici décrites plus en détail.

Dans cet exemple de mise en œuvre, le traitement thermique est effectué avant les étapes E7, E8 de dépôt de l'oxyde transparent conducteur 111 (TCO) et des contacts métalliques 112 car celles-ci sont réalisées par des techniques peu agressives, sans bombardement. Un exemple d'un telle technique est la déposition par couches atomiques, également appelée ALD pour « Atomic Layer Déposition » en anglais.

Dans un autre exemple de mise en œuvre, dans lequel l'étape E7 de dépôt de l'oxyde transparent conducteur 111 est effectuée par déposition physique en phase vapeur (PVD), qui est une technique agressive, le traitement thermique est effectué après le dépôt de l'oxyde transparent conducteur 111. Le traitement thermique peut alors être couplé avec le recuit de sérigraphie.

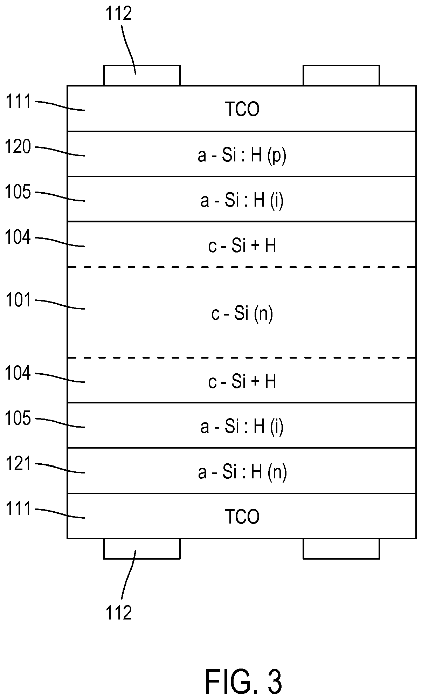

Un deuxième exemple de mise en œuvre du procédé de fabrication d'une cellule photovoltaïque à hétérojonction selon l'invention va maintenant être décrit, en référence à la figure 3. Dans cet exemple, l'étape d'implantation ionique d'hydrogène illustré à la figure 1B est effectuée sur les deux faces du substrat 101. L'implantation ionique peut se faire simultanément sur les deux faces du substrat 101, ou une face après l'autre. Un réservoir d'hydrogène 104 est formé de chaque côté du substrat 101.

Une couche de passivation 105, par exemple en silicium amorphe hydrogéné a-Si:H intrinsèque, est déposée sur chaque face du substrat 101. Alternativement, le silicium amorphe hydrogéné a-Si:H peut être microdopé, à une dose de préférence comprise entre 10¹⁶ at/cm² et 10¹⁹ at/cm².

Une première couche semi-conductrice 120 et une deuxième couche semi-conductrice 121, par exemple en silicium amorphe hydrogéné a-Si:H, respectivement dopées p et n sont déposées de part et d'autre du substrat 101. En l'occurrence, les couches semi-conductrices 120, 121 sont chacune déposées sur l'une des couches de passivation 105.

La première couche semi-conductrice 120 dopée p, donc de type de conductivité opposé à celui du substrat 101, forme l'émetteur de la cellule photovoltaïque.

La deuxième couche semi-conductrice 121 dopée n, donc du même type de conductivité que celui du substrat 101, forme une couche de champ répulsif pour les porteurs de charge minoritaires du substrat 101.

Dans le cas où les couches de passivation 105 sont en silicium amorphe hydrogéné a-Si:H microdopé, le type de conductivité de chaque couche de passivation 105 est le même que celui de la couche semi-conductrice qui est déposée sur cette couche de passivation 105. Du côté de l'émetteur, le silicium amorphe hydrogéné a-Si:H microdopé est de type p. Du côté du champ répulsif, le silicium amorphe hydrogéné a-Si:H microdopé est de type n.

Le procédé de fabrication de la cellule photovoltaïque de la figure 3 comporte également une étape de formation de contacts électriques de part et d'autre de la cellule photovoltaïque. Pour ce faire, une couche conductrice électriquement 111 est par exemple déposée sur chaque couche semi-conductrice 120, 121. Les couches conductrices 111 sont de préférence formées d'un oxyde transparent conducteur TCO tel que l'oxyde d'indium et d'étain (ITO pour « Indium Tin Oxide » en anglais). Ensuite, des contacts métalliques 112 sont formés sur les couches conductrices 111 pour collecter le courant photogénéré. Les contacts métalliques 112 se présentent par exemple sous la forme de peignes métalliques.

Dans cet exemple de mise en œuvre, le procédé peut comporter une seule étape de traitement thermique, commune à la diffusion de l'hydrogène sur les deux faces du substrat 101, ou alors deux traitements thermiques spécifiques, chacun étant optimisé pour une face du substrat 101.

Naturellement, l'invention n'est pas limitée aux modes de mise en œuvre décrits en référence aux figures et des variantes pourraient être envisagées sans sortir du cadre de l'invention.

## Revendications

1. Procédé de fabrication d'une cellule photovoltaïque à hétérojonction, le procédé comportant les étapes suivantes :
- (E1) fournir un substrat en silicium cristallin (101) ;
- (E2) implanter des ions d'hydrogène en surface du substrat (101), à travers une première face (103) du substrat (101) ;
- (E3) déposer une couche de passivation (105) sur la première face (103) du substrat (101) ;
- (E4) effectuer un traitement thermique à une température inférieure à 250°C de sorte que les ions d'hydrogène implantés dans le substrat (101) diffusent vers l'interface (103) entre le substrat (101) et la couche de passivation (105).

2. Procédé selon la revendication 1 comportant en outre des étapes (E5) de fabrication susceptibles de provoquer une dégradation de l'interface (103) entre le substrat (101) et la couche de passivation (105), le traitement thermique (E4) étant effectué postérieurement à ces étapes (E5).

3. Procédé selon l'une quelconque des revendications 1 à 2 dans lequel le traitement thermique (E4) est effectué à une température comprise entre 100°C et 220°C.

4. Procédé selon l'une quelconque des revendications 1 à 3 dans lequel le traitement thermique (E4) est effectué pendant une durée comprise entre 1 minute et 30 minutes.

5. Procédé selon l'une quelconque des revendications 1 à 4 dans lequel l'implantation ionique (E2) d'hydrogène est réalisée par immersion dans un plasma.

6. Procédé selon l'une quelconque des revendications 1 à 5 dans lequel l'implantation ionique (E2) d'hydrogène est effectuée à une énergie inférieure à 1keV.

7. Procédé selon l'une quelconque des revendications 1 à 6 dans lequel l'implantation ionique (E2) d'hydrogène est réalisée à une dose comprise entre 10¹³ atomes/cm³ et 10¹⁷ atomes/cm³.

8. Procédé selon l'une quelconque des revendications 1 à 7 dans lequel le traitement thermique est un recuit de sérigraphie, un recuit d'activation de dopants, ou toute étape de dépôt spécifique effectuée à une température comprise entre 100°C et 250°C.

9. Procédé selon l'une quelconque des revendications 1 à 8 dans lequel la couche de passivation (105) comprend du silicium amorphe, éventuellement hydrogéné, de l'alumine, un oxyde thermique et/ou un nitrure de silicium de type SiNₓH.

10. Procédé selon l'une quelconque des revendications 1 à 9 dans lequel l'étape d'implantation ionique (E2) d'hydrogène et l'étape de dépôt (E3) d'une couche de passivation (105) sont en outre mises en œuvre sur une deuxième face du substrat (101) opposée à la première face (103).

## Patentansprüche

1. Herstellungsverfahren einer photovoltaischen Zelle mit Heteroübergang, wobei das Verfahren die folgenden Schritte umfasst:
- (E1) Liefern eines Substrats aus kristallinem Silizium (101);
- (E2) Einsetzen der Wasserstoffionen an der Oberfläche des Substrats (101) durch eine erste Seite (103) des Substrats (101);
- (E3) Aufbringen einer Passivierungsschicht (105) auf der ersten Seite (103) Substrats (101);
- (E4) Durchführen einer Wärmebehandlung bei einer Temperatur von unter 250° C derart, dass die in dem Substrat (101) eingesetzten Wasserstoffionen sich zur Schnittstelle (103) zwischen dem Substrat (101) und der Passivierungsschicht (105) verteilen.

2. Verfahren gemäß Anspruch 1, umfassend darüber hinaus Herstellungsschritte (E5), die geeignet sind, eine Beschädigung der Schnittstelle (103) zwischen dem Substrat (101) und der Passivierungsschicht (105) hervorzurufen, wobei die Wärmebehandlung (E4) nach diesen Schritten (E5) durchgeführt wird.

3. Verfahren gemäß irgendeinem der Ansprüche 1 bis 2, bei dem die Wärmebehandlung (E4) bei einer zwischen 100° C und 220° C inbegriffenen Temperatur durchgeführt wird.

4. Verfahren gemäß irgendeinem der Ansprüche 1 bis 3, bei dem die Wärmebehandlung (E4) während einer zwischen 1 Minute und 30 Minuten inbegriffenen Dauer durchgeführt wird.

5. Verfahren gemäß irgendeinem der Ansprüche 1 bis 4, bei dem das ionische Einsetzen (E2) von Wasserstoff per Eintauchen in ein Plasma realisiert wird.

6. Verfahren gemäß irgendeinem der Ansprüche 1 bis 5, bei dem das ionische Einsetzen (E2) von Wasserstoff bei einer Energie von weniger als 1 keV durchgeführt wird.

7. Verfahren gemäß irgendeinem der Ansprüche 1 bis 6, bei dem das ionische Einsetzen (E2) von Wasserstoff bei einer zwischen 10¹³ Atomen/cm³ und 10¹⁷ Atomen/cm³ inbegriffenen Dosis realisiert wird.

8. Verfahren gemäß irgendeinem der Ansprüche 1 bis 7, bei dem die Wärmebehandlung ein Siebdruckglühen, eine Aktivierungsglühen von Dotierungsstoffen oder jeder spezifische Aufbringungsschritt ist, der bei einer zwischen 100° C und 250° C inbegriffenen Temperatur durchgeführt wird.

9. Verfahren gemäß irgendeinem der Ansprüche 1 bis 8, bei dem die Passivierungsschicht (105) amorphes, eventuell wasserstoffhaltiges Silizium, Aluminiumoxid, ein thermisches Oxid und / oder ein Siliziumnitrid vom Typ SiNₓH umfasst.

10. Verfahren gemäß irgendeinem der Ansprüche 1 bis 9, bei dem der Schritt des ionischen Einsetzens (E2) von Wasserstoff und der Schritt des Aufbringens (E3) einer Passivierungsschicht (105) darüber hinaus auf einer zweiten Seite des der ersten Seite (103) entgegengesetzten Substrats (101) umgesetzt sind.

## Claims

1. Method for manufacturing a heterojunction photovoltaic cell, the method comprising the following steps:
- (E1) providing a crystalline silicon substrate (101);
- (E2) implanting hydrogen ions at the surface of the substrate (101), through a first face (103) of the substrate (101);
- (E3) depositing a passivation layer (105) on the first face (103) of the substrate (101);
- (E4) performing a thermal treatment at a temperature lower than 250°C so that the hydrogen ions implanted in the substrate (101) diffuse towards the interface (103) between the substrate (101) and the passivation layer (105).

2. Method according to claim 1, further comprising manufacturing steps (E5) likely to cause a degradation of the interface (103) between the substrate (101) and the passivation layer (105), the thermal treatment (E4) being performed subsequently to these steps (E5).

3. Method according to any one of claims 1 and 2, wherein the thermal treatment (E4) is performed at a temperature between 100°C and 220°C.

4. Method according to any one of claims 1 to 3, wherein the thermal treatment (E4) is performed for a duration between 1 minute and 30 minutes.

5. Method according to any one of claims 1 to 4, wherein the ionic implantation (E2) of hydrogen is performed by immersion in a plasma.

6. Method according to any one of claims 1 to 5, wherein the ionic implantation (E2) of hydrogen is performed at an energy lower than 1keV.

7. Method according to any one of claims 1 to 6, wherein the ionic implantation (E2) of hydrogen is performed at a dose between 10¹³ atoms/cm³ and 10¹⁷ atoms/cm³.

8. Method according to any one of claims 1 to 7, wherein the thermal treatment is a screen-printing annealing, an annealing for activating dopants, or any specific deposition step performed at a temperature between 100°C and 250°C.

9. Method according to any one of claims 1 to 8, wherein the passivation layer (105) comprises amorphous silicon, possibly hydrogenated, alumina, a thermal oxide and/or an SiNₓH type silicon nitride.

10. Method according to any one of claims 1 to 9, wherein the step of ionic implantation (E2) of hydrogen and the step of depositing (E3) a passivation layer (105) are further performed on a second face of the substrate (101) opposite the first face (103).
